# EUROPÄISCHE PATENTSCHRIFT

(11) **EP 2 315 044 B1**
(45) Veröffentlichungstag und Bekanntmachung des Hinweises auf die Patenterteilung: **19.09.2012**
(21) Anmeldenummer: 09013425.5
(22) Anmeldetag: 23.10.2009
(51) Int. Cl.: G01R 33/022, G01R 33/04, G01V 3/10

(54) **Differenzmagnetometersonde**
Difference magnetometer probe
Sonde de magnétomètre différentiel

(43) Veröffentlichungstag der Anmeldung: 27.04.2011
(73) Patentinhaber: Ebinger, Klaus, 51149 Köln (DE)
(72) Erfinder: Ebinger, Klaus, 51149 Köln (DE)
(74) Vertreter: Heim, Hans-Karl

(56) Entgegenhaltungen:
- EP-A2- 0 945 736
- DE-A1- 2 942 847
- DE-A1- 4 232 466
- DE-U1-202005 009 419
- DE-U1-202005 020 193

## Beschreibung

Die Erfindung betrifft eine Differenzmagnetometersonde mit einem ersten und einem zweiten Magnetfeldsensor, welche voneinander beabstandet vorgesehen sind. Die Magnetfeldsensoren weisen jeweils einen Induktorstreifen und einen Induktor auf. Hierbei ist der Induktorstreifen des ersten Magnetfeldsensors und der Induktorstreifen des zweiten Magnetfeldsensors auf einem Spannband angeordnet und befestigt. Durch die Anordnung auf dem Spannband sind die Induktorstreifen koaxial ausgerichtet. Ferner weist die Differenzmagnetometersonde eine Einrichtung zur Symmetrieauswertung für Signale des ersten und des zweiten Magnetfeldsensors auf.

Des Weiteren betrifft die Erfindung ein Verfahren zum Kalibrieren einer Differenzmagnetometersonde, bei dem ein Spannband in eine amagnetische Spanneinrichtung eingespannt wird und Signale eines ersten Magnetfeldsensors und eines zweiten Magnetfeldsensors einer Symmetrieauswertung unterzogen werden.

Zur Lösung typischer Suchaufgaben im Erdboden oder in Gewässern haben sich Differenzmagnetometersonden, welche auch als Saturationsmagnetometer bezeichnet werden, in der Art eines Feldstärkedifferenzmessers durchgesetzt.

Grundlage einer derartigen Differenzmagnetometersonde bilden zwei magnetempfindliche Induktoren, welche als Magnetfeldsensoren bezeichnet werden. Diese sind koaxial mit einem vorgegebenen Basisabstand in einem Suchrohr angeordnet. Magnetometersonden werden auch als Vertikaldifferenzsonden bezeichnet. Mit ihnen können ferromagnetische Störungen im Erdmagnetfeld nachgewiesen werden. Durch diese Störungen können Rückschlüsse auf vorhandene ferromagnetische Objekte getätigt werden.

Beide Magnetfeldsensoren können bei einer gattungsgemäßen Suchanordnung in Differenz geschaltet sein, so dass die Signale der Magnetfeldsensoren, welche die Feldstärke des elektromagnetischen Erdfeldes anzeigen, sich gegenseitig kompensieren. Ein in der Nähe des Magnetometers befindliches ferromagnetisches Objekt bewirkt eine Störung in dem magnetischen Erdfeld, beziehungsweise das Eigenfeld des ferromagnetischen Objektes überlagert sich mit dem Erdfeld. Durch Annäherung der Magnetometersonde an das ferromagnetische Objekt sowie durch den räumlichen Abstand der beiden Magnetfeldsensoren zueinander entsteht nach Betrag und Richtung ein Differenzsignal, welches optisch und akustisch ausgegeben werden kann.

Gattungsgemäße Magnetometersonden sind sehr empfindlich. Sie müssen etwa 100.000stel der Totalintensität des Erdfeldes auflösen. Hierdurch sind sie in der Lage, Differenzfeldstärken im Nanotesla-Bereich festzustellen. Dies bedeutet, dass die Magnetfeldsensoren sehr genau arbeiten müssen, so dass Unterschiede im Nanotesla-Bereich zwischen den von zwei Magnetfeldsensoren gemessenen Feldstärken in der Differenzauswertung ermittelt werden können. Differenzmagnetometersonden können somit zur Suche von tiefliegenden ferromagnetischen Teilen, wie beispielsweise Bomben, eingesetzt werden. Wesentliche Voraussetzungen für das Erreichen einer derart hohen Messgenauigkeit ist die sogenannte Parallelisierung der beiden Magnetfeldsensoren.

Die bei gattungsgemäßen Differenzmagnetometersonden eingesetzten Magnetfeldsensoren werden herkömmlicherweise aus einem Induktorstreifen und aus mehreren Spulen, welche um den Induktorstreifen angeordnet sind, aufgebaut. Der Induktorstreifen besteht bevorzugt aus einem weichmagnetischen Material, welches eine hohe magnetische Permeabilität aufweist. Um diesen Induktorstreifen sind die Spulen angeordnet, wobei meist eine Primär- und Sekundärspule vorgesehen ist. Der Induktorstreifen wird von der Primärspule durch ein magnetisches Wechselfeld bis zu seiner Sättigung magnetisiert. Dies wird auch als Durchmagnetisieren bezeichnet.

Durch Hysterese-Effekte in den Induktorstreifen werden Oberwellen erzeugt, sofern ein äußeres Magnetfeld, im Falle einer Differenzmagnetometersonde das Erdmagnetfeld, auf die Magnetfeldsensoren einwirkt. Diese Oberwellen werden anhand der Sekundärspule analysiert. Hierdurch ist es möglich, sehr genaue Aussagen über das externe Magnetfeld zu erhalten.

Es werden jedoch sehr hohe Anforderungen an die Parallelisierung der Induktorstreifen gestellt. Deshalb wurde die sogenannte Spannbandtechnik eingeführt. Diese ist beispielsweise in DE 29 42 847 beschrieben. Hierbei werden die Induktorstreifen auf oder an einem amagnetischen Draht befestigt. Dieser Draht selbst ist gespannt. Durch die Verwendung der Spannbandtechnik konnte die Langzeitkonstanz von Differenzmagnetometersonden verbessert werden, da eine aufwändige mechanische Parallelisierung der Lage der Induktorstreifen entfallen konnte.

Hierauf aufbauende Differenzmagnetometersonden verwenden im Wesentlichen zwei zylindrische Erregertransformatoren, die mit dem Sondenträger, der rohr- oder wannenförmig ausgeführt sein kann, exakt fluchtend befestigt sind. Die Erregertransformatoren weisen jeweils eine zylindrische Öffnung auf, durch die das Spannband berührungslos verläuft. Auf dem Spannband sind Induktorstreifen angebracht, die im Bereich der Öffnungen der Erregertransformatoren vorgesehen sind. Hierbei besteht idealerweise keine Berührung zwischen den Induktorstreifen und den Erregertransformatoren. Dies setzt eine hohe Präzision in der Positionierung der Induktorstreifen voraus, da eine Dejustierung der Streifenposition im Erregerfeld zu elektrischen Unsymmetrien und damit zu fälschlich detektierten Magnetfelddifferenzen führt. Diese sollten beim Differenzmagnetometer standardmäßig nicht vorliegen, da über das Vorhandensein von Magnetfelddifferenzen die zu detektierenden Objekte erkannt werden.

Solche gattungsgemäßen Differenzmagnetometersonden sind beispielsweise aus DE 20 2005 009 419 U1 oder US 3,487,459 bekannt. Bei diesen Sonden wird ein sehr großer Aufwand betrieben, um eine parallele Ausrichtung der Induktorstreifen und der Primär- und Sekundärspulen der Magnetfeldsensoren zu erreichen, wodurch eine mechanisch komplexe Ausführung notwendig ist.

Eine Verbesserung von Magnetfeldsensoren ist bereits aus dem europäischen Patent 09 45 736 B1 bekannt. Dort ist beschrieben, dass es möglich ist, auf die Sekundärspulen zu verzichten, und Magnetfeldsensoren lediglich mit einer Spule auszuführen, welche als Erregerspule und gleichzeitig als Sensorspule eingesetzt werden kann.

Aus der DE 42 32 466 A1 ist eine Magnetometersonde mit zwei magnetischen Induktoren bekannt, die im Wesentlichen koaxial zum Sondengehäuse angeordnet sind. Um eine wirkungsvolle parallele Ausrichtung beider Induktoren zu erreichen, ist zumindest ein Induktor um eine quer zur Achse des Sondengehäuses gelegene Schwenkachse verschwenkbar gelagert.

In der DE 20 2005 020 193 U1 ist ein Kalibriergenerator beschrieben, bei dem über Kalibrierspulen ein definiertes magnetisches Feld im unmittelbaren Bereich der Magnetfeldsonde erzeugt wird, das von den an dem Sensorrohr angebrachten zu kalibrierenden Magnetfeldsensoren gemessen wird. Die Kalibrierspulen sind in sogenannten Abgleichköpfen angeordnet, die sich relativ zu den an dem zylindrischen Sensorrohr angebrachten Magnetfeldsensoren verschieben lassen. Dadurch lässt sich für die Kalibrierung eine definierte magnetische Flussdichte in den beiden Magnetfeldsensoren erzeugen, die mit den über die Magnetfeldsensoren gemessenen Magnetfelder abgeglichen werden kann.

Der Erfindung liegt die **Aufgabe** zugrunde, eine Differenzmagnetometersonde zu schaffen, welche einen einfachen Aufbau und eine hohe Detektionsgenauigkeit aufweist sowie ein Kalibrierverfahren für eine derartige Differenzmagnetometersonde anzugeben.

Die Aufgabe wird erfindungsgemäß durch eine Differenzmagnetometersonde mit den Merkmalen des Anspruchs 1 sowie durch ein Verfahren zur Kalibrierung einer Differenzmagnetometersonde mit den Merkmalen des Anspruchs 10 gelöst.

Weitere vorteilhafte Ausführungen sind in den abhängigen Ansprüchen, der Beschreibung sowie den Figuren und der Figurenbeschreibung angegeben.

Gemäß dem Anspruch 1 weist eine erfindungsgemäße Differenzmagnetometersonde Induktoren auf, welche jeweils eine Wicklung, insbesondere eine einzige Wicklung, aufweisen. Hierbei sind die Induktorstreifen des Magnetfeldsensors von der Wicklung des jeweiligen Induktors umschlossen, wobei die Induktoren mittels der Induktorstreifen an dem Spannband befestigt sind.

Ein Grundgedanke der Erfindung kann darin gesehen werden, die verwendeten Magnetfeldsensoren aus einem Induktorstreifen und lediglich einer einzigen Spule mit einer Wicklung aufzubauen. Diese Wicklung wird auch als Monowickel bezeichnet. Aufgrund des Aufbaus der Induktoren mit einer einzigen Wicklung sind diese einfacher in der Herstellung und bedeutend leichter als Induktoren bekannter Magnetfeldsensoren. So ist es möglich, die Induktoren auf den Induktorstreifen zu befestigen und nicht wie bei gattungsgemäßen Differenzmagnetometersonden am Sondenträger. So können die Induktoren die Induktorstreifen direkt ohne Zwischenraum umschließen.

Ein weiterer wesentlicher Aspekt der Erfindung ist es, dass das Spannband mit den beiden Induktorstreifen und den dazugehörigen Induktoren eine Einheit bildet. Diese kann auch als elektromagnetische Einheit bezeichnet werden. Dadurch, dass die Induktoren an den Induktorstreifen befestigt sind, ist eine bessere Langzeitkonstanz der Justierung der beiden durch die Induktorstreifen und die Induktoren gebildeten Magnetfeldsensoren zueinander gegeben.

Ein weiterer Vorteil für den Betrieb einer Differenzmagnetometersonde ergibt sich daraus, dass die Induktorstreifen vom jeweiligen Induktor umschlossen sind.

Hierdurch kann eine unmittelbare Kopplung realisiert werden, da die Induktorwicklung den Induktorstreifen unmittelbar umschließt. Ein dämpfender Luftspalt zwischen dem Induktor und dem Induktorstreifen wird damit verhindert. Hierdurch ist es möglich, die Induktorstreifen leichter durchzumagnetisieren als bei bekannten Sondensystemen. Folglich kann die erfindungsgemäße Differenzmagnetometersonde mit einem geringeren Erregerstrom betrieben werden, da kein großer Abstand zwischen den Induktorstreifen und den Induktoren überwunden werden muss.

Ein weiterer eigenständiger Gedanke der Erfindung ist es, dass das Spannband mit den angebrachten Magnetfeldsensoren quasi eine komplette Sensoreinheit ausbildet. Es ist lediglich notwendig, das Spannband zu spannen, und die Magnetfeldsensoren an eine entsprechende Auswertung anzuschließen. Hierdurch ist es äußerst einfach, die Differenzmagnetometersonde zu kalibrieren, da die Kalibrierung separat für das Spannband ausgeführt werden kann. Das Spannband mit den Magnetometersensoren wird dann nach einer erfolgreichen Kalibrierung in einen Sondenträger für eine Differenzmagnetometersonde eingebracht.

Es wird bevorzugt, wenn jeweils eine direkte mechanische Verbindung zwischen dem Induktor und dem jeweiligen Induktorstreifen vorgesehen ist. Hierdurch ist der Induktor an dem Induktorstreifen befestigt und bildet somit mit dem Induktorstreifen eine Einheit. Bei Magnetfeldsensoren des Standes der Technik war der Induktorstreifen an dem Spannband gespannt und die Induktoren der Magnetfeldsensoren waren um den Induktorstreifen derart angeordnet, so dass dieser berührungslos durch sie hindurchlief.

Durch diese herkömmliche Konstruktion sind aus der Fachliteratur Stoßmodulationen durch externe Schockbelastungen auf die Sonde bekannt, da das gespannte Spannband wie eine Saite mit dem Induktor schwingen konnte. Diese Stoßmodulationen sind ungewollt, da sie die geforderte hohe Genauigkeit der Differenzmagnetometersonden negativ beeinflussen. Durch die direkte mechanische Verbindung zwischen Induktor und Induktorstreifen im Zusammenhang mit einem Magnetfeldsensor, welcher eine äußerst geringe Masse aufweist, können derartige Stoßmodulationen größtenteils vermieden werden. Somit können Magnetfeldsensoren hergestellt werden, welche extrem leichte Induktoren aufweisen, die nur eine Wicklung, welche auch als Monowickel bezeichnet wird, besitzen.

In einer bevorzugten Ausführungsform ist die Einrichtung zur Symmetrieauswertung als Einrichtung zur Differenzauswertung ausgebildet. Hierbei können die in den jeweiligen Magnetfeldsensoren erzeugten Signale, beispielsweise Oberwellen, miteinander in Differenz gesetzt werden, wobei zusätzlich eine unterschiedliche Phase berücksichtigt werden kann. Die Ergebnisanzeige kann beispielsweise mit einer Analoganzeige durchgeführt werden, welche im Symmetriefall den Nullpunkt, also den Abgleich der beiden Signale, anzeigt.

Es ist vorteilhaft, wenn die Wicklung der Induktoren jeweils zwei Anschlüsse aufweist und ein Anschluss der Wicklung des Induktors des ersten Magnetfeldsensors mit einem Anschluss der Wicklung des Induktors des zweiten Magnetfeldsensors zusammengeschaltet ist. Ferner ist bevorzugt, wenn die Einrichtung zur Symmetrieauswertung der Signale der Magnetfeldsensoren mit dem zusammengelegten Anschluss der Wicklungen und den zwei weiteren Anschlüssen der Wicklungen zur Signalauswertung verbunden ist. Eine derartige Verschaltung der Einrichtung zur Symmetrieauswertung beruht darauf, dass erkannt wurde, dass zur Analyse der entstehenden Oberwellen keine separaten Spulen notwendig sind, sondern die Erregerspulen zusätzlich hierfür verwendet werden können. Hierdurch müssen nur drei Anschlüsse zur Verbindung der Induktoren mit einer nachgeschalteten Auswertung zur Verfügung gestellt werden.

Bevorzugt ist das Spannband mit den beiden an ihm angebrachten Magnetfeldsensoren in einem Sondenträger vorgesehen. Dieser Sondenträger kann rohrförmig ausgeführt sein, wobei insbesondere nur ein einzelner Sondenträger vorgesehen ist. In diesem rohrförmigen Sondenträger ist das Spannband befestigt. Auf das im Stand der Technik verwendete zweite Schutzrohr kann bei der erfindungsgemäßen Differenzmagnetometersonde verzichtet werden, da die Magnetfeldsensoren, das heißt insbesondere die Induktoren sowie die Induktorstreifen, direkt mit dem Spannband verbunden sind. Hierdurch können sich die Induktoren bezüglich der Induktorstreifen bei äußeren Einwirkungen, wie Stößen auf die Sonde, nicht oder nur sehr gering verschieben. Der Sondenträger, der nicht zwangsweise rohrförmig ausgeführt sein muss, kann aus einem hochfesten Kunststoffrohr in GFK- oder CFK-Technik ausgeführt sein. Der Sondenträger kann auch als Gehäuse der Differenzmagnetometersonde bezeichnet werden.

Weiterhin kann eine Einrichtung zur magnetischen Parallelisierung der beiden Magnetfeldsensoren zueinander vorgesehen sein. Eine derartige Einrichtung ermöglicht es, die Anforderungen beim Aufbau einer Differenzmagnetometersonde, insbesondere bei deren Kalibrierung, geringer auszuführen und eine spätere eventuell auftretende Dejustierung einfach ohne großen Aufwand beheben zu können.

Bevorzugt ist die Einrichtung zur magnetischen Parallelisierung als Feinkalibrierungseinrichtung ausgeführt und weist einen Kalibrierungsinduktorstreifen auf. Eine Feinkalibrierungseinrichtung für die Differenzmagnetometersonde ist allerdings nicht grundsätzlich notwendig, sondern nur im Zusammenhang mit äußerst hochempfindlichen Bombensuchgeräten, die beispielsweise Gegenstände in einer großen Tiefe detektieren sollen. Für einfache Magnet- und Eisensuchgeräte bedarf es nicht unbedingt einer Feinkalibrierungseinrichtung.

Die Feinkalibrierungseinrichtung weist einen Kalibrierungsinduktorstreifen auf, der ähnlich aufgebaut sein kann, wie die Induktorstreifen der Magnetfeldsensoren. Der Kalibrierungsinduktorstreifen wird bevorzugt im Bereich eines Induktorstreifens eines Magnetfeldsensors angebracht. Beim Betrieb der Magnetfeldsensoren wird durch den Kalibrierungsinduktorstreifen ein zusätzlicher magnetischer Vektor in Induktornähe erzeugt, der quasi den störenden magnetischen Vektor, der durch eine nicht ausreichende Parallelisierung der beiden Magnetfeldsensoren zueinander entstehen kann, kompensiert.

Für eine exakte Ausrichtung der Feinkalibrierungseinrichtung hat sich herausgestellt, dass es vorteilhaft ist, wenn diese um die Längsachse des Sondenträgers drehbar angeordnet ist. Zusätzlich kann die Feinkalibrierungseinrichtung verschiebbar, insbesondere längsverschiebbar, auf dem Sondenträger vorgesehen sein. Die Feinkalibrierungseinrichtung kann als Hülse ausgeführt sein, welche über den Sondenträger geschoben wird und mit einer bevorzugterweise amagnetischen, idealerweise aus Kunststoff bestehenden, Befestigungseinrichtung an dem Sondenträger befestigt wird. Die Ausbildung der Feinkalibrierungseinrichtung als Hülse ermöglicht eine äußerst einfache Ausführung, die trotzdem leicht justiert werden kann.

Bevorzugterweise ist der Kalibrierungsinduktorstreifen in einem Winkel von etwa 35° bis 45°, insbesondere 40°, zum Spannband der Feinkalibrierungseinrichtung vorgesehen. Es hat sich herausgestellt, dass mit einer Ausrichtung des Kalibrierungsinduktorstreifens in einem derartigen Winkel zum Spannband, eine effektive quasi Parallelisierung der Magnetfeldsensoren zueinander erreicht werden kann.

Ferner betrifft die Erfindung ein Verfahren zum Kalibrieren einer Differenzmagnetometersonde, bei dem ein Spannband in eine amagnetische Spanneinrichtung eingespannt wird und bei dem Signale eines ersten Magnetfeldensors und eines zweiten Magnetfeldsensors einer Symmetrieauswertung unterzogen werden. Des Weiteren ist vorgesehen, dass Induktoren der Magnetfeldsensoren im Bereich jeweiliger Induktorstreifen längs des Spannbandes verschoben werden und dass die Induktoren der Magnetfeldsensoren an den Induktorstreifen fixiert werden, wenn die Auswertung eine Symmetrie der Signale ergibt.

Es wird also das Spannband einer Spannbandsonde, welche auch als Differenzmagnetometersonde bezeichnet werden kann, in eine externe Spann- und Prüfvorrichtung eingesetzt und abgeglichen. Der Abgleich erfolgt dadurch, dass die Induktoren, welche auch als Induktorwickel bezeichnet werden können, über die Induktorstreifen geschoben werden. Währenddessen werden die Signale der Induktoren ausgewertet. Die Induktoren werden nur dann fixiert, wenn die Sensorik der Auswertung ergeben hat, dass eine Symmetrie der Signale der beiden Induktoren vorliegt.

Vorteilhaft am erfindungsgemäßen Verfahren ist es, dass im Gegensatz zu bekannten Differenzmagnetometersonden lediglich das Spannband einer Justierung und Kalibrierung unterzogen werden muss. Nachdem die Induktoren an den Induktorstreifen und somit am Spannband befestigt sind, kann das Spannband entspannt werden und in eine Differenzmagnetometersonde eingebaut oder einer anderen Einrichtung zugeführt werden.

Bevorzugt ist es, wenn ein Anschluss einer Wicklung des Induktors des ersten Magnetfeldsensors und ein Anschluss einer Wicklung des Induktors des zweiten Magnetfeldsensors zusammengeschaltet werden und wenn die zusammengeschalteten Anschlüsse und je ein weiterer Anschluss jeder Wicklung an die Symmetrieauswertung angeschlossen werden. Die Symmetrieauswertung kann dann die in den Wicklungen entstehenden Oberwellen auswerten. Weiterhin müssen im Vergleich zum Aufbau und der Verwendung von Magnetfeldsensoren mit einer Primär- und Sekundärwicklung zum Erregen und separaten Empfangen der Oberwellen lediglich drei Anschlüsse an die Symmetrieauswertungseinrichtung angeschlossen werden, wodurch der Anschlussaufwand verringert wird und so eine Kalibrierung eines Spannbandes schneller durchgeführt werden kann.

Bevorzugt wird die Symmetrieauswertung der Signale als Differenzauswertung durchgeführt. Grundsächlich ist eine Symmetrieauswertung auch in anderer Weise möglich, jedoch bietet die Differenzauswertung insbesondere den Vorteil, dass sie relativ einfach und somit robust durchgeführt werden kann.

Zu der Symmetrieauswertung der Signale wird in einer bevorzugten Ausführungsform eine Wechselstrombrücke mit phasenselektiver Anzeige verwendet. Hierbei wird der Symmetriezustand durch eine Nullanzeige der phasenselektiven Anzeige dargestellt.

Grundsätzlich kann mit dem beschriebenen Verfahren eine sehr hohe Genauigkeit der Parallelisierung der beiden Magnetfeldsensoren zueinander erreicht werden. Um jedoch eine noch höhere Genauigkeit zu erreichen ohne den Kalibrierungsaufwand unverhältnismäßig stark zu erhöhen, ist es bevorzugt, dass für eine Feinkalibrierung eine Kalibrierhülse mit einem Kalibrierungsinduktorstreifen verwendet wird, welche im Bereich des Gehäuses der Differenzmagnetometersonde positioniert wird. Hierbei kann der Kalibrierungsinduktorstreifen in einem Winkel von etwa 35° bis 45°, insbesondere 40°, zu dem Spannband vorgesehen werden.

Die Kalibrierhülse kann auf dem Gehäuse der Differenzmagnetometersonde verschoben und/oder bezüglich der Längsachse des Gehäuses gedreht werden, bis eine Symmetrie der Signale der Magnetfeldsensoren erreicht wird. Der Kalibrierungsinduktorstreifen erzeugt im Zusammenhang mit einem externen Magnetfeld, wie beispielsweise dem Erdmagnetfeld, einen Ausgleichsvektor, der eine Positionierung der Magnetfeldsensoren geringfügig außerhalb einer exakten Parallelisierung kompensiert. Durch die Kalibrierhülse wird quasi ein weiterer magnetischer Vektor erzeugt, der dem Anteil des Vektors eines Magnetfeldsensors entgegenwirkt, der die Nichtparallelisierung anzeigt.

Die Erfindung wird nachfolgend anhand von Ausführungsbeispielen und schematischen Zeichnungen näher erläutert. In diesen Zeichnungen zeigen:
- Fig. 1: einen vereinfachten Aufbau eines Spannbandes einer erfin- dungsgemäßen Differenzmagnetometersonde; und
- Fig. 2: eine erfindungsgemäße Differenzmagnetometersonde mit Kalibrierhülse.

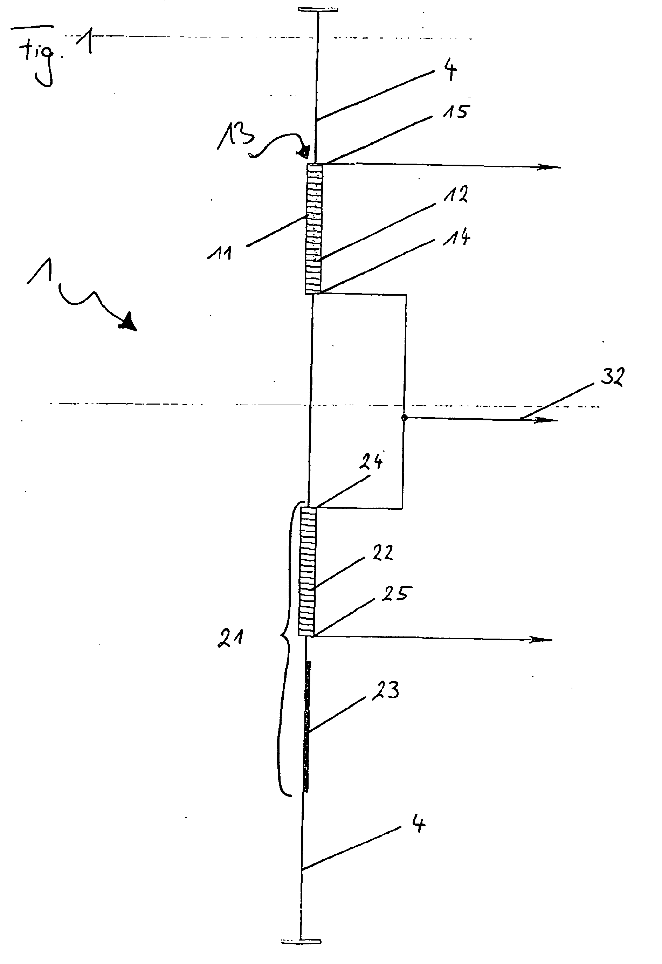

In Fig. 1 ist ein stark vereinfachter Aufbau eines Spannbandes 4 für eine erfindungsgemäße Differenzmagnetometersonde 1 dargestellt. An dem Spannband 4 sind zwei Induktorstreifen 13 und 23 befestigt, wobei der Induktorstreifen 13 nicht sichtbar ist. Der Induktorstreifen 23 bildet zusammen mit einem Induktor 22 einen Magnetfeldsensor 21. In gleicher Weise wird durch den nicht dargestellten Induktorstreifen 13 mit einem Induktor 12 ein Magnetfeldsensor 11 gebildet. Die Induktoren 12, 22 der Magnetfeldsensoren 11, 21 sind jeweils aus einer Spule ausgebildet. Diese Spule kann auch als Wickel bezeichnet werden. Der Induktor 12 weist zwei Anschlüsse 14 und 15 auf. Der Induktor 22 ist analog zum Induktor 12 aufgebaut und weist ebenfalls zwei Anschlüsse 24 und 25 auf. Die beiden Anschlüsse 14 und 24 sind zu dem gemeinsamen Anschluss 32 zusammengeschaltet.

In Fig. 1 ist das Spannband 4 auf einer externen Spann- und Prüfvorrichtung eingespannt, um die Induktoren 12, 22 und die Induktorstreifen 13, 23 exakt zu positionieren. Hierbei werden zuerst die Induktorstreifen 13, 23 auf dem Spannband, idealerweise koaxial, ausgerichtet. Anschließend werden die Induktoren 12, 22 über die am Spannband 4 befestigten Induktorstreifen 13, 23 geschoben. Die Wicklungsausgänge 15, 32 und 25 der Induktoren 12, 22 werden an einem Prüfgerät (nicht dargestellt) angeschlossen. Hierbei führt das Prüfgerät eine Differenzauswertung der Signale, insbesondere der entstandenen Oberwellen, in den Induktoren 12 und 22 durch. Das Prüfgerät übernimmt hierbei die Funktion der Differenzmagnetometerelektronik. Dies bedeutet, dass es zur Anzeige des Unterschiedes der Signale der beiden Magnetfeldsensoren eingerichtet ist. Es wird nun der Induktor 22 über den Induktorstreifen 23 geschoben, bis die Differenzanzeige des Prüfgerätes eine Nullanzeige ausführt. Dies bedeutet, dass die beiden Magnetfeldsensoren 11 und 21 dasselbe Signal ausgeben. Hieraus kann geschlossen werden, dass diese Induktoren 12, 22 ausreichend genau bezüglich der Induktorstreifen 13, 23 ausgerichtet sind. Liefern beide Magnetfeldsensoren 11, 21 dasselbe beziehungsweise ein sich gegenseitig auslöschendes Signal zu dem Erdmagnetfeld, so werden die Induktoren 12, 22 an den Induktorstreifen 13, 23 fixiert.

Diese Auswertung der Signale der Magnetfeldsensoren 11, 21 funktioniert im Prinzip wie eine Wechselstrombrücke mit phasenselektiver Anzeige. Um lediglich den Einfluss des Erdmagnetfeldes zu berücksichtigen, wird der Kalibriervorgang, der auch als Abgleichvorgang oder Vorabgleich bezeichnet werden kann, fern jeglicher Eisensubstanzen vorgenommen. Eine im Wesentlichen vorhandene Symmetrie der beiden Signale der Magnetfeldsensoren 11, 21 ist notwendig, um den sogenannten Schaukeleffekt beim Betrieb im Erdmagnetfeld zu reduzieren.

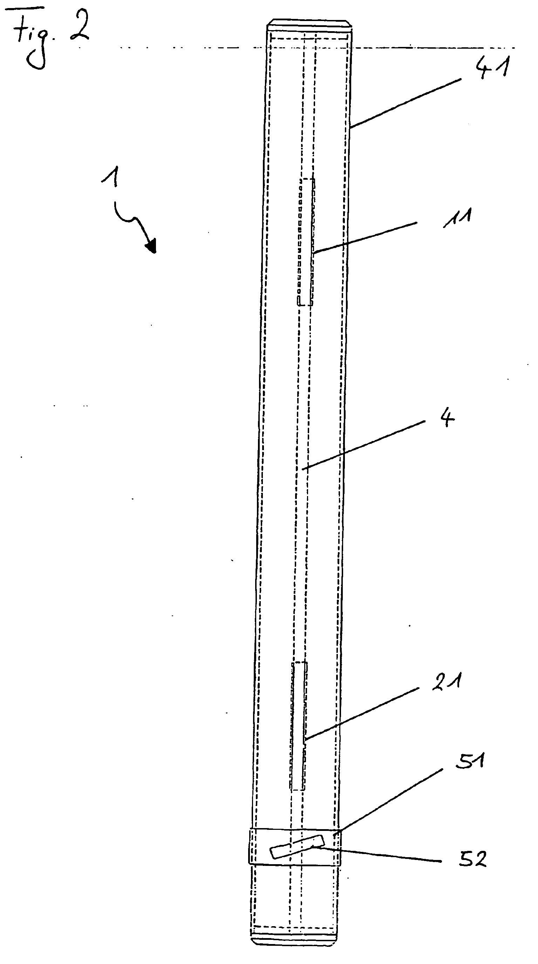

In Fig. 2 ist eine erfindungsgemäße Differenzmagnetometersonde 1 dargestellt. Hierbei ist das Innere der Differenzmagnetometersonde 1 durch gestrichelte Linien verdeutlicht. Im Inneren der Differenzmagnetometersonde 1 befindet sich ein Spannband 4. An dem Spannband 4 sind zwei Magnetfeldsensoren 11 und 21 befestigt. Das Spannband 4 besteht vorzugsweise aus einer hochfesten amagnetischen Metalliegierung geringer elektrischer Leitfähigkeit, um Wirbelstromverluste im Erregerfeld zu vermeiden. Die Magnetfeldsensoren 11 und 21 sind, wie bereits in Bezug auf Fig. 1 ausgeführt, jeweils aus einem Induktor 12, 22 und einem Induktorstreifen 13, 23 aufgebaut.

Die Induktorstreifen 13, 23 sind aus einem weichmagnetischen Werkstoff mit einer hohen Permeabilität aufgebaut, welcher sich in einem elektromagnetischen Wechselfeld relativ leicht bis in die Sättigung durchmagnetisieren lässt. Die Induktorstreifen 13, 23 werden exakt fluchtend von den Induktoren 12, 22 umschlossen.

Die beiden Magnetfeldsensoren 11 und 21 können mit einer Differenzauswertung verbunden sein, wie sie bereits in Bezug auf Fig. 1 angesprochen wurde. Die Ergebnisse der Differenzauswertung können über eine nicht dargestellte Anzeigeeinrichtung der erfindungsgemäßen Differenzmagnetometersonde 1 ausgegeben werden. Dies kann beispielsweise in Form einer Spannungsanzeige erfolgen. Hierdurch wird durch das Vorzeichen verdeutlicht, im Bereich welches Magnetfeldsensors 11, 21 sich die Abnormalität des Erdmagnetfeldes befindet. In Fig. 2 wurde darauf verzichtet, die Elektronikeinheit, welche für die Auswertung der Signale der Magnetfeldsensoren 11, 21 notwendig ist, darzustellen. Die Elektronikeinheit kann mit heutigen Mitteln sehr klein gestaltet werden, so dass sie in vielfältiger Weise in der Differenzmagnetometersonde 1 beziehungsweise in dem Sondenträger 41 untergebracht werden kann.

Zeigt die Anzeige im Ruhezustand der Sonde 1, das heißt im Zustand, in dem die Differenzmagnetometersonde 1 nicht benutzt wird, eine Anzeige an, beispielsweise eine Restspannung, so liegt eine Dejustierung der Magnetfeldsensoren 11, 21 zueinander vor. Dies bedeutet, dass diese nicht mehr genau parallel zueinander ausgerichtet sind. Eine Dejustierung kann für bestimmte Aufgabenbereiche, in denen eine hochgenaue Detektion notwendig ist, kompensiert werden. Hierzu ist an einem Ende der Differenzmagnetometersonde 1 eine Kalibrierhülse 51 vorgesehen, welche über den Sondenträger 41 der Differenzmagnetometersonde 1 geschoben werden kann. Diese Kalibrierhülse 51 weist einen Kalibrierungsinduktorstreifen 52 auf. Dieser ist in einem Winkel von ca. 40° zu dem Spannband 4 vorgesehen.

Die Kalibrierhülse 51 kann auf dem Sondenträger 41 in Längsrichtung verschoben und um die Längsrichtung gedreht werden. Hierdurch ist es möglich, mittels des Kalibrierungsinduktorstreifens 52, welcher an der Kalibrierhülse 51 angebracht ist, eine leichte magnetische Nichtparallelität der beiden Magnetfeldsensoren 11, 21 zueinander auszugleichen. Eine derartige Feinjustierung ist allerdings nur für Differenzmagnetometersonde notwendig, die als hochempfindliche Sensorgeräte, beispielsweise zur Bombensuche, mit einer entsprechend geforderten Hochauflösung verwendet werden. Für einfachere Magnet- und Eisensuchgeräte ist dies nicht erforderlich. Anders ausgedrückt, ist es durch den Kalibrierungsinduktorstreifen 52 auf der Kalibrierhülse 51 möglich, eine erforderliche magnetische Parallelität der zwei Magnetfeldsensoren 11, 21 in einfacher Weise exakt einzustellen.

Die erfindungsgemäße Differenzmagnetometersonde zeichnet sich durch einen einfachen Aufbau und eine hohe Detektionsgenauigkeit sowie durch eine erhöhte Langzeitstabilität aus. Durch das erfindungsgemäße Kalibrierverfahren für eine Spannbandsonde, beispielsweise einer Differenzmagnetometersonde, kann das Spannband separat kalibriert werden, wodurch der Aufbau einer Differenzmagnetometersonde vereinfacht wird.

## Patentansprüche

1. Differenzmagnetometersonde
mit einem ersten (11) und einem zweiten Magnetfeldsensor (21), die voneinander beabstandet vorgesehen sind, und
jeweils einen Induktorstreifen (13, 23) und einen Induktor (12, 22) aufweisen,
wobei die Induktorstreifen (13, 23) des ersten (11) und des zweiten Magnetfeldsensors (21) auf einem Spannband (4) angeordnet sind und koaxial ausgerichtet sind, und
mit einer Einrichtung zur Symmetrieauswertung für die Signale des ersten (11) und des zweiten Magnetfeldsensors (21),
**dadurch gekennzeichnet,**
**dass** die Induktoren (12, 22) jeweils eine Wicklung, insbesondere eine einzige Wicklung, aufweisen,
**dass** der Induktorstreifen (13, 23) jedes Magnetfeldsensors (11, 21) von der Wicklung des jeweiligen Induktors (12, 22) umschlossen ist und
**dass** die Induktoren (12, 22) jeweils mittels der Induktorstreifen (13, 23) an dem Spannband (4) befestigt sind.

2. Differenzmagnetometersonde nach Anspruch 1,
**dadurch gekennzeichnet,**
**dass** eine jeweils direkte mechanische Verbindung zwischen dem Induktor (12, 22) und dem Induktorstreifen(13, 23) vorgesehen ist.

3. Differenzmagnetometersonde nach Anspruch 1 oder 2,
**dadurch gekennzeichnet,**
**dass** die Einrichtung zur Symmetrieauswertung als Einrichtung zur Differenzauswertung ausgebildet ist.

4. Diflerenzmagnetometersonde nach einem der Ansprüche 1 bis 3,
**dadurch gekennzeichnet,**
**dass** die Wicklung der Induktoren (12, 22) jeweils zwei Anschlüsse (14, 15, 24, 25) aufweist,
**dass** ein Anschluss (14) der Wicklungen des Induktors (12) des ersten Magnetfeldsensors (11) mit einem Anschluss (24) der Wicklung des Induktors (22) des zweiten Magnetfeldsensors (21) zusammengeschaltet ist und dass die Einrichtung zur Symmetrieauswertung der Signale der Magnetfeldsensoren (11, 21) mit dem zusammengelegten Anschluss (32) der Wicklungen und den zwei weiteren Anschlüssen (15, 25) der Wicklungen zur Signalauswertung verbunden ist.

5. Differenzmagnetometersonde nach einem der Ansprüche 1 bis 4,
**dadurch gekennzeichnet,**
**dass** ein rohrförmiger Sondenträger (41), insbesondere ein einzelner, rohrförmiger Sondenträger, vorgesehen ist und
**dass** in dem rohrförmigen Sondenträger (41) das Spannband (4) befestigt ist.

6. Differenzmagnetometersonde nach einem der Ansprüche 1 bis 5,
**dadurch gekennzeichnet,**
**dass** eine Einrichtung zur magnetischen Parallelisierung der beiden Magnetfeldsensoren (11, 21) zueinander vorgesehen ist.

7. Differenzmagnetometersonde nach einem der Ansprüche 1 bis 6,
**dadurch gekennzeichnet,**
**dass** die Einrichtung zur magnetischen Parallelisierung als Feinkalibrierungseinrichtung (51) ausgeführt ist und
**dass** die Feinkalibrierungseinrichtung (51) einen Kalibrierungsinduktorstreifen (52) aufweist.

8. Differenzmagnetometersonde nach einem der Ansprüche 5 bis 7,
**dadurch gekennzeichnet,**
**dass** die Feinkalibrierungseinrichtung (51) drehbar um die Längsachse des Sondenträgers (41) am Sondenträger (41) angeordnet und verschiebbar auf dem Sondenträger (41) vorgesehen ist.

9. Differenzmagnetometersonde nach einem der Ansprüche 7 oder 8,
**dadurch gekennzeichnet,**
**dass** der Kalibrierungsinduktorstreifen (52) in einem Winkel zur Längsrichtung des Spannbands (4) an der Feinkalibrierungseinrichtung (51) vorgesehen ist.

10. Verfahren zum Kalibrieren einer Differenzmagnetometersonde,
insbesondere einer Differenzmagnetometersonde (1) nach einem der Ansprüche 1 bis 9,
bei dem ein Spannband (4) in einer amagnetischen Spanneinrichtung eingespannt wird,
bei dem Signale eines ersten Magnetfeldsensors (11) und eines zweiten Magnetfeldsensors (21) einer Symmetrieauswertung unterzogen werden, **dadurch gekennzeichnet,**
**dass** Induktoren (12, 22) der Magnetfeldsensoren (11, 21) längs im Bereich jeweiliger Induktorstreifen (13, 23) die auf einem Spannbande (4) angeordnet sind, verschoben werden und
**dass** die Induktoren (12, 22) der Magnetfeldsensoren (11, 21) an den Induktorstreifen (13, 23) fixiert werden, wenn die Auswertung eine Symmetrie der Signale ergibt.

11. Verfahren zur Kalibrierung einer Differenzmagnetometersonde nach Anspruch 10,
**dadurch gekennzeichnet,**
**dass** ein Anschluss (14) einer Wicklung des Induktors (12) des ersten Magnetfeldsensor (11) und ein Anschluss (24) einer Wicklung des Induktors (22) des zweiten Magnetfeldsensors (21) zusammengeschaltet werden und
**dass** die zusammengeschalteten Anschlüsse (32) und je ein weiterer Anschluss (15, 25) jeder Wicklung an die Symmetrieauswertung angeschlossen werden.

12. Verfahren zur Kalibrierung einer Differenzmagnetometersonde nach Anspruch 10 oder 11,
**dadurch gekennzeichnet,**
**dass** die Symmetrieauswertung der Signale als Differenzauswertung durchgeführt wird.

13. Verfahren zur Kalibrierung einer Differenzmagnetometersonde nach einem der Ansprüche 10 bis 12,
**dadurch gekennzeichnet,**
**dass** für die Symmetrieauswertung der Signale eine Wechselstrombrücke mit phasenselektiver Anzeige verwendet wird.

14. Verfahren zur Kalibrierung einer Differenzmagnetometersonde nach einem der Ansprüche 10 bis 13,
**dadurch gekennzeichnet,**
**dass** für eine Feinkalibrierung eine Kalibrierhülse (51) mit einem Kalibrierungsinduktorstreifen (52) verwendet wird, welche im Bereich des Sondenträgers (41) der Differenzmagnetometersonde positioniert wird,
wobei der Kalibrierungsinduktorstreifen (52) in einem Winkel zur Längsrichtung des Spannbands (4) vorgesehen wird.

15. Verfahren zur Kalibrierung einer Differenzmagnetometersonde nach einem der Ansprüche 10 bis 14,
**dadurch gekennzeichnet,**
**dass** die Kalibrierhülse (51) auf dem Sondenträger (41) der Differenzmagnetometersonde (1) verschoben und/oder bezüglich der Längsachse des Sondenträgers (41) gedreht wird, bis eine Symmetrie der Signale der Magnetfeldsensoren (11, 21) erreicht wird.

## Claims

1. Difference magnetometer probe,
with a first (11) and a second magnetic field sensor (21) which are provided spaced apart from each other and
respectively comprise an inductor strip (13, 23) and an inductor (12, 22),
wherein the inductor strips (13, 23) of the first (11) and the second magnetic field sensor (21) are arranged on a tension band (4) and are coaxially orientated, and
with a means for symmetry evaluation for the signals of the first (11) and the second magnetic field sensor (21),
**characterised in that**
the inductors (12, 22) respectively comprise a winding, in particular an individual winding,
the inductor strip (13, 23) of each magnetic field sensor (11, 21) is surrounded by the winding of the respective inductor (12, 22) and
the inductors (12, 22) are respectively fixed by means of the inductor strips (13, 23) to the tension band (4).

2. Difference magnetometer probe according to claim 1,
**characterised in that**
a respectively direct mechanical connection is provided between the inductor (12, 22) and the inductor strip (13, 23).

3. Difference magnetometer probe according to claim 1 or 2,
**characterised in that**
the means for symmetry evaluation is designed as a means for difference evaluation.

4. Difference magnetometer probe according to one of the claims 1 to 3,
**characterised in that**
the winding of the inductors (12, 22) respectively comprises two connections (14, 15, 24, 25),
a connection (14) of the windings of the inductor (12) of the first magnetic field sensor (11) is connected to a connection (24) of the winding of the inductor (22) of the second magnetic field sensor (21) and
the means for symmetry evaluation of the signals of the magnetic field sensors (11, 21) is connected to the put-together connection (32) of the windings and the two further connections (15, 25) of the windings for signal evaluation.

5. Difference magnetometer probe according to one of the claims 1 to 4,
**characterised in that**
a tubular probe carrier (41), in particular an individual tubular probe carrier, is provided and
the tension band (4) is fixed in the tubular probe carrier (41).

6. Difference magnetometer probe according to one of the claims 1 to 5,
**characterised in that**
a means for magnetic parallelisation of the two magnetic field sensors (11, 21) relative to each other is provided.

7. Difference magnetometer probe according to one of the claims 1 to 6,
**characterised in that**
the means for magnetic parallelisation is designed as a fine calibration means (51) and
the fine calibration means (51) comprises a calibration inductor strip (52).

8. Difference magnetometer probe according to one of the claims 5 to 7,
**characterised in that**
the fine calibration means (51) is arranged on the probe carrier (41) so that it can be rotated about the longitudinal axis of the probe carrier (41) and is provided displaceably on the probe carrier (41).

9. Difference magnetometer probe according to one of the claims 7 or 8,
**characterised in that**
the calibration inductor strip (52) is provided at an angle to the longitudinal direction of the tension band (4) on the fine calibration means (51).

10. Method for calibrating a difference magnetometer probe,
in particular a difference magnetometer probe (1) according to one of the claims 1 to 9,
wherein a tension band (4) is tensioned in a non-magnetic tension means,
wherein signals of a first magnetic field sensor (11) and a second magnetic field sensor (21) are subject to a symmetry evaluation,
**characterised in that**
inductors (12, 22) of the magnetic field sensors (11, 21) are displaced longitudinally in the region of respective inductor strips (13, 23) which are arranged on a tension band (4),
and
the inductors (12, 22) of the magnetic field sensors (11, 21) are fixed on the inductor strips (13, 23) if the evaluation produces a symmetry of the signals.

11. Method for calibration of a difference magnetometer probe according to claim 10,
**characterised in that**
a connection (14) of a winding of the inductor (12) of the first magnetic field sensor (11) and a connection (24) of a winding of the inductor (22) of the second magnetic field sensor (21) are connected together and
the connected-together connections (32) and a further respective connection (15, 25) of each winding are connected to the symmetry evaluation.

12. Method for calibrating a difference magnetometer probe according to claim 10 or 11,
**characterised in that**
the symmetry evaluation of the signals is carried out as a difference evaluation.

13. Method for calibrating a difference magnetometer probe according to one of the claims 10 to 12,
**characterised in that**
an alternating current bridge with phase-selective display is used for the symmetry evaluation of the signals.

14. Method for calibrating a difference magnetometer probe according to one of the claims 10 to 13,
**characterised in that**
a calibration sleeve (51) with a calibration inductor strip (52) is used for a fine calibration, which calibration sleeve (51) is positioned in the region of the probe carrier (41) of the difference magnetometer probe,
wherein the calibration inductor strip (52) is provided at an angle to the longitudinal direction of the tension band (4).

15. Method for calibrating a difference magnetometer probe according to one of the claims 10 to 14,
**characterised in that**
the calibration sleeve (51) is displaced on the probe carrier (41) of the difference magnetometer probe (1) and / or is rotated relative to the longitudinal axis of the probe carrier (41) until a symmetry of the signals of the magnetic field sensors (11, 21) is achieved.

## Revendications

1. Sonde de magnétomètre différentiel
avec un premier (11) et un deuxième (21) capteurs de champ magnétique qui sont prévus à distance l'un de l'autre, et
qui comprennent chacun une bande (13, 23) d'inducteur et un inducteur (12, 22),
dans lequel les bandes (13, 23) d'inducteur du premier (11) et du deuxième (21) capteurs de champ magnétique sont placées sur une bande de serrage (4) et orientées de manière coaxiale, et
avec un dispositif d'analyse de symétrie pour les signaux du premier (11) et du deuxième (21) capteurs de champ magnétique,
***caractérisée***
***en* ce *que*** les inducteurs (12, 22) comprennent chacun un enroulement, en particulier un enroulement unique,
***en ce que*** la bande (13, 23) d'inducteur de chaque capteur de champ magnétique (11, 21) est entourée par l'enroulement de l'inducteur (12, 22) respectif, et
***en ce que*** les inducteurs (12, 22) sont fixés chacun à la bande de serrage (4) au moyen de la bande (13, 23) d'inducteur.

2. Sonde de magnétomètre différentiel selon la revendication 1,
*caractérisée en ce qu*'une liaison mécanique directe respective est prévue entre l'inducteur (12, 22) et la bande (13, 23) d'inducteur.

3. Sonde de magnétomètre différentiel selon la revendication 1 ou 2,
***caractérisée en ce que*** le dispositif d'analyse de symétrie est conformé en dispositif d'analyse différentielle.

4. Sonde de magnétomètre différentiel selon l'une quelconque des revendications 1 à 3,
***caractérisée***
***en ce que*** l'enroulement des inducteurs (12, 22) comprend deux branchements (14, 15, 24, 25),
*en ce qu*'un branchement (14) des enroulements de l'inducteur (12) du premier capteur (11) de champ magnétique est raccordé en commun avec un branchement (24) de l'enroulement de l'inducteur (22) du deuxième capteur (21) de champ magnétique, et
***en ce que*** le dispositif d'analyse de symétrie des signaux des capteurs (11, 21) de champ magnétique est relié au branchement commun (32) des enroulements et aux deux autres branchements (15, 25) des enroulements pour analyser le signal.

5. Sonde de magnétomètre différentiel selon l'une quelconque des revendications 1 à 4,
*caractérisée*
*en ce qu*'un support tubulaire (41) de sonde est prévu, en particulier un support de sonde tubulaire unique, et
*en ce que* la bande de serrage (4) est fixée dans le support tubulaire (41) de sonde.

6. Sonde de magnétomètre différentiel selon l'une quelconque des revendications 1 à 5, *caractérisée en ce qu*'un dispositif est prévu pour paralléliser magnétiquement les deux capteurs (11, 21) de champ magnétique l'un par rapport à l'autre.

7. Sonde de magnétomètre différentiel selon l'une quelconque des revendications 1 à 6,
***caractérisée***
***en ce que*** le dispositif de parallélisation magnétique est réalisé sous forme de dispositif de calibrage fin (51), et
***en ce que*** le dispositif (51) de calibrage fin comprend une bande (52) d'inducteur de calibrage.

8. Sonde de magnétomètre différentiel selon l'une quelconque des revendications 5 à 7, ***caractérisée en ce que*** le dispositif de calibrage fin (51) est monté sur le support (41) de sonde de manière rotative autour de l'axe longitudinal du support (41) de sonde et est prévu mobile sur le support (41) de sonde.

9. Sonde de magnétomètre différentiel selon la revendication 7 ou 8, ***caractérisé en ce que*** la bande (52) d'inducteur de calibrage est prévue sur le dispositif (51) de calibrage fin en formant un angle par rapport à la direction longitudinale de la bande de serrage (4).

10. Procédé de calibrage d'une sonde de magnétomètre différentiel,
en particulier d'une sonde (1) de magnétomètre différentiel selon l'une quelconque des revendications 1 à 9,
dans lequel une bande de serrage (4) est serrée dans un dispositif de serrage amagnétique,
dans lequel des signaux d'un premier capteur (11) de champ magnétique et d'un deuxième capteur (21) de champ magnétique sont soumis à une analyse de symétrie,
***caractérisé***
***en ce que*** les inducteurs (12, 22) des capteurs (11, 21) de champ magnétique sont déplacés longitudinalement au niveau de bandes (13, 23) d'inducteur respectives qui sont placées sur une bande de serrage (4), et
***en ce que*** les inducteurs (12, 22) des capteurs (11, 21) de champ magnétique sont fixés sur les bandes (13, 23) d'inducteur quand l'analyse révèle une symétrie des signaux.

11. Procédé de calibrage d'une sonde de magnétomètre différentiel selon la revendication 10,
***caractérisé***
***en ce qu'****un* branchement (14) d'un enroulement de l'inducteur (12) du premier capteur (11) de champ magnétique et un branchement (24) de l'enroulement de l'inducteur (22) du deuxième capteur (21) de champ magnétique sont raccordés en commun, et
***en ce que*** les branchements (32) raccordés en commun et un autre branchement (15, 25) respectif de chaque enroulement sont raccordés à l'analyse de symétrie.

12. Procédé de calibrage d'une sonde de magnétomètre différentiel selon la revendication 10 ou 11,
***caractérisé en ce que*** l'analyse de symétrie des signaux est conduite sous forme d'analyse différentielle.

13. Procédé de calibrage d'une sonde de magnétomètre différentiel selon l'une quelconque des revendications 10 à 12,
***caractérisé en ce qu'**un* pont à courant alternatif avec affichage sélectif de phase est utilisé comme analyse de symétrie des signaux.

14. Procédé de calibrage d'une sonde de magnétomètre différentiel selon l'une quelconque des revendications 10 à 13,
***caractérisé en ce que**,* pour un calibrage fin, une douille (51) de calibrage avec une bande (52) d'inducteur de calibrage est utilisée, laquelle est placée au niveau du support (41) de la sonde de magnétomètre différentiel,
dans lequel la bande (52) d'inducteur de calibrage est prévue suivant un angle par rapport à la direction longitudinale de la bande de serrage (4).

15. Procédé de calibrage d'une sonde de magnétomètre différentiel selon l'une quelconque des revendications 10 à 14,
***caractérisé* en ce *que*** la douille (51) de calibrage est déplacée sur le support de sonde (41) de la sonde (1) de magnétomètre différentiel et/ou est tournée par rapport à l'axe longitudinal du support (41) de sonde, jusqu'à obtenir une symétrie des signaux des capteurs (11, 21) de champ magnétique.
